# EUROPÄISCHE PATENTSCHRIFT

(11) **EP 2 792 221 B1**
(45) Veröffentlichungstag und Bekanntmachung des Hinweises auf die Patenterteilung: **26.08.2015**
(21) Anmeldenummer: 11805771.0
(22) Anmeldetag: 14.12.2011
(51) Int. Cl.: H05K 1/11, A47B 97/00, A47F 5/08, A47F 11/10

(54) **SYSTEM MIT EINRICHTUNG ZUR ZUFUHR ELEKTRISCHER ENERGIE AN EINEN VERBRAUCHER**
SYSTEM WITH DEVICE FOR SUPPLYING ELECTRICAL ENERGY TO A LOAD
SYSTÈME AVEC DISPOSITIF D'ALIMENTATION D'UN CONSOMMATEUR EN ÉNERGIE ÉLECTRIQUE

(43) Veröffentlichungstag der Anmeldung: 22.10.2014
(73) Patentinhaber: Dula-Werke Dustmann & Co. GmbH, 44225 Dortmund (DE)
(72) Erfinder: MEIS, Alfons, 46286 Dorsten (DE)
(74) Vertreter: Buse, Mentzel, Ludewig Patentanwaltskanzlei
(86) Internationale Anmeldenummer: PCT/EP2011/006306
(87) Internationale Veröffentlichungsnummer: WO 2013/087081

(56) Entgegenhaltungen:
- EP-A2- 0 472 420
- DE-U1-202006 006 185
- DE-U1-202009 005 428
- GB-A- 2 356 295
- US-A- 4 969 827
- US-A- 4 974 121
- US-A1- 2006 228 913
- US-A1- 2008 043 456
- US-B1- 6 200 146

## Beschreibung

Die Erfindung betrifft eine Einrichtung zur Zufuhr elektrischer Energie an einen Verbraucher sowie ein System zur Elektrifizierung zumindest eines Verbrauchers mit einer solchen Einrichtung. Solche Einrichtungen werden beispielsweise verwendet, um einen Verbraucher mit elektrischer Energie zu versorgen. Als Verbraucher kommen insbesondere Leuchten, Displays, Lautsprecher oder auch Vorschaltgeräte für andere elektrische Verbraucher in Betracht. Die Einrichtungen werden häufig im Ladenbau, Messebau oder generell in der Inneneinrichtung verwendet.

Die EP 2 242 349 A 2 beschreibt eine Vorrichtung zur Zufuhr elektrischer Energie an einen Verbraucher. Diese Vorrichtung kann auch beispielsweise im Ladenbau, Messebau oder Innenausbau eingesetzt werden, um Verbraucher, wie beispielsweise Leuchten, mit elektrischer Energie zu versorgen. Nachteilig bei dieser Vorrichtung ist jedoch, dass ein Verbraucher an die verbrauchseitigen Kontaktflächen angeschlossen werden muss. Dies geschieht üblicherweise mittels einer Lötverbindung. Eine solche Lötverbindung muss jedoch von einem Fachmann durchgeführt werden. Außerdem kann es häufig vorkommen, dass die Lötstelle Schwachstellen aufweist. Darüber hinaus ist es nur schwer möglich, einen anderen Verbraucher an die Vorrichtung anzuschließen, da dann zunächst die Lötstelle des alten Verbrauchers gelöst werden muss, eventuelle Lötreste entfernt werden müssen und dann ein neuer Verbraucher durch Anlöten wieder angebracht werden kann.

Weitere, den Stand der Technik beschreibende Veröffenlichungen sind EP 0 472 420 A2, US 2006/228913 A1, US 2008/043456 A1 und GB 2 356 295 A, DE 20 2006 006185 U1, US 6 200 146 B1, DE 20 2009 005428 U1, US 4 969 827 A und US 4 974 121 A.

Aufgabe der Erfindung ist es daher, die vorgenannte Vorrichtung zu verbessern und auch für nicht Fachleute bedienbar zu machen. Weiterhin ist es Aufgabe der Erfindung, ein System zur Elektrifizierung von Verbrauchern zur Verfügung zu stellen. Diese Aufgabe wird durch die kennzeichnenden Merkmale von Anspruch 1 gelöst denen folgende besondere Bedeutung zukommt:

Auf dem Tragelement ist ein Stecker vorgesehen, welcher die verbraucherseitigen Enden der Leiterbahn umfasst und worüber eine elektrische Verbindung zum Verbraucher erfolgen kann. Diese Anordnung hat den Vorteil, dass jedermann, also auch Nichtfachkräfte, den Verbraucher an das Tragelement anschließen können. Auch können Fehler, die beispielsweise durch schlechte Lötstellen entstehen, vermieden werden. Auch ist das Auswechseln der Verbraucher, die über die Einrichtung mit elektrischer Energie versorgt werden sollen, sehr einfach und mit wenigen Handgriffen zur erledigen.

Bei dem System ist neben der bereits beschriebenen einen Stecker umfassenden Einrichtung auch noch wenigstens ein Träger vorgesehen, welcher entweder direkt das Möbelelement darstellt, wie beispielsweise einen Abhängearm oder der ein Möbelelement, wie einen Regalboden, eine Kleiderstange oder Ähnliches, trägt. An dem Träger oder dem Möbelelement ist an einem Verbraucher mittelbar oder unmittelbar anbringbar. Weiterhin ist ein senkrechtes Profil vorgesehen, welches bevorzugt in einem Gehäuse angeordnet ist und an welchem der jeweilige Träger angeordnet werden kann. Das Profil weist dabei wenigstens eine, bevorzugt jedoch zwei Stromschienen, auf. Die Einrichtung ist dann auf den Träger aufbringbar, beispielsweise durch Kleben, aber auch durch Löten, Schweißen, Nieten oder irgendeine andere Verbindung und die Leiterbahnen auf dem Tragelement bzw. der Stecker der Einrichtung wird dann durch Einhaken, Einstecken oder Einhängen des Trägers in das Profil elektrifiziert. Selbstverständlich ist es auch möglich, den Träger anderweitig im Profil festzulegen. Bevorzugterweise ist der Stecker unlösbar mit dem Tragelement verbunden. Hierbei ist es besonders vorteilhaft, wenn der Stecker sehr flach ausgeführt ist, so dass er bei einem zusammengebauten System kaum zu sehen ist. Besonders bevorzugt ist es, den Stecker direkt bei der Produktion des Tragelementes mit in dieses zu integrieren.

Bevorzugterweise ist der Stecker als weiblicher Stecker ausgebildet. Hierdurch wird eine Beschädigung bzw. ein Verbiegen der Steckerkontakte beim Aufbringen der Einrichtung auf den Träger vermieden.

In einem besonders bevorzugten Ausführungsbeispiel ist der Stecker so ausgebildet, dass der entsprechende zugehörige Gegenstecker nur in eine Richtung aufsteckbar ist. Da die Vorrichtung überwiegend bei Gleichstrom eingesetzt wird, kann so eine Verpolung vermieden werden. Je nach Art des Verbrauchers wäre eine solche Verpolung ungünstig und könnte zur Beschädigung des Verbrauchers führen, Um den Gegenstecker nur in eine Richtung aufsteckbar zu machen, kann beispielsweise die Form des weiblichen Steckers so angepasst sein, dass die Kontakte unterschiedlich ausgebildet sind oder der Stecker an sich eine nicht vollständig symmetrische Form aufweist, so dass der Gegenstecker nur in einer Richtung mit der Form des Steckers korrespondiert.

In der Erfindung ist das Tragelement flexibel ausgestaltet. So kann es sich unterschiedlich geformten Trägern anpassen. Als Tragelement kann dann beispielsweise eine Folie dienen. Diese kann dann die Leiterbahnen tragen, welche beispielsweise aus verzinnter Kupferfolie bestehen könne. Solch ausgestaltetes Tragelement kann dann den unterschiedlichsten Anwendungsfällen dienen.

In der Erfindung weist das Tragelement auf einer Seite eine selbstklebende Klebstoffschicht auf und/oder auf der anderen Seite eine elektrisch isolierende Schutzschicht. Sind beide Schichten vorgesehen, kann das Tragelement besonders einfach auf einen Träger ausgeklebt werden. Auch ein Kurzschluss zwischen den Leiterbahnen des Tragelementes kann einfach vermieden werden, wenn eine isolierende Schutzschicht vorgesehen ist. Auch bei der Inbetriebnahme der Einrichtung bzw. beim Austausch eines Verbrauchers kann die Bedienperson das Trageelement im Bereich der elektrischen Leiterbahnen berühren ohne einen Kurzschluss auszulösen.

Um die Vorrichtung besonders unauffällig zu gestalten, können das Tragelemente und/oder die Klebstoffschicht und/oder die Schutzschicht transparent bzw. farblos ausgebildet werden. Die auf einem Träger so angebrachte Einrichtung ist beim üblichen Gebrauch des am Möbel befindlichen Trägers kaum wahrnehmbar. Sie kann so unauffällig angeordnet werden und stört nicht das optische Gesamtbild.

Weitere Vorteile und Ausführungsformen der Erfindung ergeben sich aus der nachfolgenden Beschreibung, den Unteransprüchen sowie den Zeichnungen. In den Zeichnungen ist die Erfindung in einem Ausführungsbeispiel dargestellt. Es zeigen:
- Fig. 1:: die erfindungsgemäße Einrichtung perspektivisch,
- Fig. 2:: ein System mit erfindungsgemäßer Einrichtung aus Fig. 1 perspektivisch.

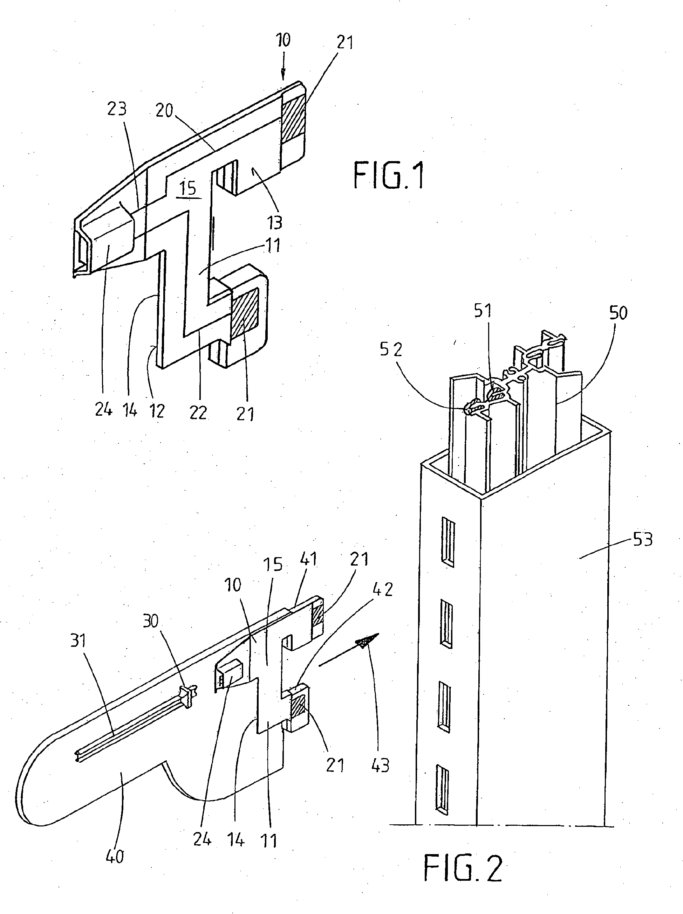

Fig. 1 zeigt die Einrichtung 10. Man erkennt das aus einer Folie bestehende Tragelement 11. Die eine Seite 12 des Tragelements 11 ist mit einer Klebstoffschicht 14 beschichtet, die selbstklebend arbeitet, während die andere Seite 13 der Einrichtung 11 mit einer Schutzschicht 15 versehen ist, die elektrisch isolierend wirkt, damit zwischen den beiden Leiterbahnen 20 kein Kurzschluss entstehen kann. Weiterhin verfügt die Einrichtung 10 über einen Stecker 24 sowie zwei Kontaktflächen 21, wobei jede der Kontaktflächen 21 mit dem Stecker 24 elektrisch kontaktwirksam über jeweils eine Leiterbahn 20 miteinander verbunden ist. Die Kontaktflächen 21 sind dabei auf der Quellenseite 22 der Leiterbahn 20 angeordnet, während sich der Stecker 24 auf der Verbraucherseite 23 der Leiterbahnen 20 befindet. Die Kontaktflächen 21 sind breiter ausgebildet als die zugehörigen Leiterbahnen 20. So ist es möglich, die Leiterbahnen 20 möglichst schmal und unauffällig im Tragelement 11 vorzusehen, während die Kontaktflächen 21 breit genug sind, um einen sicheren und einfachen Kontakt bei Einbau der Einrichtung 10 in ein System zu gewährleisten.

Ein solches System ist in Fig. 2 gezeigt. Die Einrichtung 10 ist auf einem Träger 40 angeordnet. Hierbei wurde das Tragelement 11 über die selbstklebende Klebstoffschicht 14 auf dem Träger 40 befestigt. Selbstverständlich ist es auch möglich, eine nicht selbstklebende Klebstoffschicht 14 vorzusehen oder die Einrichtung 10 auf andere Art mit dem Träger 40 zu verbinden.

Man sieht weiterhin exemplarisch dargestellt eine elektrische Verbindung 31, die über einen Gegenstecker 30 verfügt, welcher mit dem Stecker 24 in elektrisch kontaktwirksamer Lage durch einfaches Einstecken gebracht werden kann. So kann ein an der elektrischen Verbindung 31 angeordneter Verbraucher, wie beispielsweise eine Leuchte, ein Lautsprecher, ein Display oder Ähnliches auf einfache Art und Weise mit elektrischer Energie versorgt werden.

Auf die bei dem Träger 40 angeordnete Einrichtung 10 sind die beiden Kontaktflächen 21 noch zugänglich. Welche Bewandtnis dies hat, wird nun weiter erklärt werden. Das System umfasst weiterhin das Profil 50, welches zwei Stromschienen 51 und 52 aufweist, nämlich eine spannungsbeaufschlagte Stromschiene 51 sowie eine rückführende Stromschiene 52. Das Profil 50 ist in einem Gehäuse 53 angeordnet. Die beiden Stromschienen 51 und 52 sind parallel zueinander senkrecht im Profil 50 angeordnet und zwar derartig, dass die spannungsbeaufschlagte Stromschiene 51 in Einbringrichtung 43 des Trägers hinter der rückführenden Stromschiene 52 angeordnet ist. Der Träger 40 weist zwei Laschen 41, 42 auf, an denen bei montierter Einrichtung 10 die Kontaktflächen 21 des Tragelementes 11 angeordnet sind und die bei Einbringen des Trägers 40 mit den Stromschienen 51, 52 im Profil 50 in elektrisch wirksame Kontaktverbindung bringbar sind. Das Einbringen des Trägers 40 in das Profil 50 kann dabei insbesondere durch Einhaken, Einstecken bzw. Einhängen des Trägers 40 geschehen.

In der hier dargestellten bevorzugten Ausführungsform ist die eine Lasche 41, die mit der spannungsbeaufschlagten Stromschiene 51 in Eingriff bringbar ist, in Einbringrichtung 43 des Trägers 40 länger ausgebildet als die Lasche 42, die mit der rückführenden Stromschiene 52 in Eingriff bringbar ist. Durch die unterschiedliche Länge der Laschen kann sichergestellt werden, dass kein Kurzschluss zwischen den Stromschienen 51, 52 unter Zwischenschaltung des Trägers 40 stattfinden kann. Darüber hinaus wird das System auch sehr flexibel gestaltet. So können in das Profil 50 auch Träger 40 eingebracht werden, die nicht über eine Einrichtung 10 verfügen und somit auch nicht elektrifiziert werden sollen. Diese Träger 40 weisen dann zwei kürzere Laschen 42 auf, die dann beim Einbringen des so gestalteten Trägers 40 in das Profil 50 nur mit der rückführenden Stromschiene 52 in Eingriff kommen. Hierdurch kann kein Kurzschluss entstehen und es wird auch verhindert, dass der nicht elektrifizierte Träger 40 unter Spannung steht, da er eben nicht mit der spannungsbeaufschlagten Stromschiene 51 in Kontakt steht.

Abschließend sei noch darauf hingewiesen, dass die hier dargestellten Ausführungsformen nur beispielshafte Verwirklichungen der Erfindung sind. Diese ist nicht darauf beschränkt. Es sind vielmehr noch Abänderungen und Abwandlungen möglich. So kann beispielsweise der Träger eine andere Form aufweisen und muss auch nicht in einer Ebene angeordnet sein. Auch das Profil kann anders ausgestaltet sein und muss nicht zwingend in einem Gehäuse angeordnet sein. Auch die Form der Einrichtung und des Steckers können variieren. Die genauen Ausgestaltungen hängen vom jeweiligen Anwendungsfall ab.

### Bezugszeichenliste:

- 10: Einrichtung
- 11: Tragelement
- 12: eine Seite von 11
- 13: andere Seite von 11
- 14: Klebstoffschicht
- 15: Schutzschicht
- 20: Leiterbahn
- 21: Kontaktfläche
- 22: Quellenseite von 20
- 23: Verbraucherseite von 20
- 24: Stecker
- 30: Gegenstecker
- 31: elektrische Verbindung
- 40: Träger
- 41: eine Lasche
- 42: andere Lasche
- 43: Einbringrichtung von 40
- 50: Profil
- 51: spannungsbeaufschlagte Stromschiene
- 52: rückführende Stromschiene
- 53: Gehäuse

## Patentansprüche

1. System zur Elektrifizierung zumindest eines elektrischen Verbrauchers an einem Möbel im Ladenbau, umfassend:
wenigstens eine Einrichtung (10) zur Zufuhr elektrischer Energie an den bzw. die Verbraucher,
wobei ein Tragelement (11) aus elektrisch isolierendem Material, insbesondere aus einer Tragfolie, vorgesehen ist, welches zwei elektrische Leiterbahnen (20) trägt, die aus je einer elektrisch leitfähigen Schicht gebildet sind,
mit je wenigstens einer elektrisch leitfähigen Kontaktfläche (21) pro Leiterbahn (20) an der Quellenseite (22), über welche die Leiterbahn (20) mit der Spannungsquelle kontaktierbar ist,
mit einem auf dem Tragelement (11) angeordneten sehr flachen Stecker (24), welcher die verbraucherseitigen (23) Enden der Leiterbahnen (20) umfasst
wobei die elektrische Verbindung (31) zum Verbraucher über diesen Stecker (24) erfolgt;
einen oder mehrere Träger (40), welche entweder ein Möbelelement darstellen oder ein solches tragen und an welchen der bzw. die Verbraucher mittelbar oder unmittelbar anbringbar sind;
zumindest ein senkrechtes Profil (50), an welchem der oder die Träger (40) anordnenbar sind, und welches zwei senkrecht angeordnete Stromschienen (51, 52) aufweist, wobei das Profil (50) in einem Gehäuse (53) angeordnet ist;
wobei die Einrichtung (10) auf den Träger (40) aufbringbar ist, insbesondere durch Kleben, und die Leiterbahnen (20) auf dem Tragelement (11) durch Einhaken, Einstecken oder Einhängen des Trägers (40) in das Profil (50) elektrifizierbar sind
wobei das Tragelement (11) auf einer Seite (12) eine selbstklebende Klebstoffschicht (14) und/oder auf der anderen Seite (13) eine elektrisch isolierende Schutzschicht (15) aufweist und
wobei das Tragelement (11) flexibel, insbesondere als Tragfolie, ausgestaltet ist.

2. System nach Anspruch 1, **dadurch gekennzeichnet, dass** der Stecker (24) der Einrichtung (10) als weiblicher Stecker (24) ausgebildet ist.

3. System nach einem der Ansprüche 1 oder 2, **dadurch gekennzeichnet, dass** der Stecker (24) durch Löten, Kleben oder Schweißen mit dem Tragelement (11) verbunden oder mit diesem einstückig ausgebildet ist.

4. System nach einem der Ansprüche 1 bis 3, **dadurch gekennzeichnet, dass** der Stecker (24) so ausgebildet ist, dass der Gegenstecker (30) nur in einer Richtung aufsteckbar ist.

5. System nach einem der Ansprüche 1 bis 4, **dadurch gekennzeichnet, dass** das Tragelement (11) und/oder die Klebstoffschicht (14) und/oder die Schutzschicht (15) transparent und/oder farblos ausgebildet sind.

6. System nach einem der Ansprüche 1 bis 5, **dadurch gekennzeichnet, dass** die Kontaktflächen (21) der jeweiligen Leiterbahn (20) breiter ausgeführt ist als die Leiterbahn (20) selbst.

7. System nach einem der Ansprüche 1 bis 6, **dadurch gekennzeichnet, dass** der Träger (40) zwei Laschen (41, 42) aufweist, an denen bei montierter Einrichtung (10) die beiden Kontaktflächen (21) des Tragelements (11) angeordnet sind und die bei Einbringen des Trägers (40) in das Profil (50) mit den beiden Stromschienen (51, 52) des Profils (50) in elektrisch wirksame Verbindung bringbar sind.

8. System nach einem der Ansprüche 1 bis 7, **dadurch gekennzeichnet, dass** die spannungsbeaufschlagte Stromschiene (51) in Einbringrichtung (43) des Trägers (40) hinter der rückführenden Stromschiene (52) angeordnet ist.

9. System nach Anspruch 8, **dadurch gekennzeichnet, dass** die eine Lasche (41), die mit der spannungsbeaufschlagten Stromschiene (51) in Eingriff bringbar ist, in Einbringrichtung (43) des Trägers (40) länger ausgebildet ist als die andere Lasche (42), die mit der rückführenden Stromschiene (52) in Eingriff bringbar ist.

## Claims

1. A system for supplying electricity to a minimum of one electrical consumer on a piece of furniture in shop fitting, including:
a minimum of one device (10) for supplying electrical energy to the consumer or consumers,
whereby, one supporting element (11) is provided made from electrically insulating material, in particular made from a support film, which supports two electrical strip conductors (20) that are each formed from an electrical conductive layer,
each with a minimum of one electrical conductive contact surface (21) per strip conductor (20) on the source side (22), through which the strip conductor (20) can be in contact with the source of voltage,
with a very flat plug (24) arranged on the support element (11) that encompasses the ends of the strip conductors (20) on the consumer sides (23)
whereby, the electrical connection (31) to the consumer is through this plug (24);
one or more supports (40), that presents either an element of the furniture or supports such an element and on which the consumer or consumers can be indirectly or directly attached;
a minimum of one vertical profile (50), on which the support (40) or the supports (40) can be arranged and that features two vertically arranged conductor rails (51, 52), whereby, the profile (50) is arranged in a housing (53);
whereby, the device (10) can be attached on the support (40), in particular by adhesion and the strip conductors (20) on the support element (11) can be supplied by electricity by hooking on, plugging in or hanging the support (40) in the profile (50) whereby, the support element (11) features a self-adhesive layer (14) of adhesive on one side (12) and, on the other side (13), an electrically insulating protective layer (15) and
whereby, the support element (11) is arranged to be flexible, in particular as support film.

2. A device in accordance with claim 1, **characterized in that** the plug (24) on the device (10) is formed as a female plug (24).

3. A device in accordance with one of the claims 1 or 2, **characterized in that** the plug (24) is connected to the support element (11) by soldering, bonding or welding or formed as one piece with it.

4. A device in accordance with one of the claims 1 to 3, **characterized in that** the plug (24) is formed so that the mating plug (30) can only be connected in one direction.

5. A device in accordance with one of the claims 1 to 4, **characterized in that** the support element (11) and/or the adhesive layer (14) and/or the protective layer (15) is formed to be transparent and/or colourless.

6. A device in accordance with one of the claims 1 to 5, **characterized in that** the contact surfaces (21) of the strip conductor (20) is designed to be wider than the strip conductor (20) itself.

7. A device in accordance with one of the claims 1 to 6, **characterized in that** the support (40) features two lugs (41, 42), onto which both contact surfaces (21) of the support element (11) arranged when the device (10) is installed and, when inserting the support (40) into the profile (50), can be made electrically effective with both conductor rails (51, 52) of the profile (50).

8. A device in accordance with one of the claims 1 to 7, **characterized in that** the energized conductor rail (51) is arranged in the direction of insertion (43) of the support (40) at the rear of the return conductor rail (52).

9. A device in accordance with claim 8, **characterized in that** one of the lugs (41) that can be engaged with the energized conductor rail (51) is formed longer in the direction of insertion (43) of the support (40) than the other lug (42) that can be engaged with the return conductor rail (52).

## Revendications

1. Système d'électrification d'au moins un consommateur électrique contre un meuble d'aménagement de magasin, comprenant:
au moins un dispositif (10) d'alimentation du ou des consommateurs d'énergie électrique,
sachant qu'est prévu un élément support (11) en matériau isolant de l'électricité, consistant notamment en une feuille support, qui comporte deux pistes électroconductrices (20) formées chacune par une couche électroconductrice,
comprenant chacune au moins une surface de contact (21) électroconductrice par piste électroconductrice (20) sur le côté source (22), surface via laquelle la piste électroconductrice (20) peut être amenée en contact avec la source de tension,
avec un connecteur (24) très plat agencé sur l'élément porteur (11), qui comprend les extrémités côté consommateur (23) des pistes électroconductrices (20),
sachant que la jonction électrique (31) avec le consommateur a lieu via ce connecteur (24) ;
un ou plusieurs supports (40) qui soit représentent un élément de meuble soit portent un tel meuble et contre lesquels le ou les consommateurs peuvent être fixés indirectement ou directement ;
au moins un profilé (50) vertical contre lequel le support (40) ou les supports (40) peuvent être agencés, et qui présente deux rails électriques (51, 52) agencés verticalement, sachant que le profilé (50) est agencé dans un carter (53) ;
sachant que le dispositif (10) peut être monté sur le support (40), en particulier par collage, et que les pistes électroconductrices (20) sur l'élément porteur (11) sont électrifiables par accrochage, enfichage ou suspension du support (40) dans le profilé (50),
sachant que l'élément support (11) présente sur un côté (12) une couche autocollante de colle (14) et/ou sur l'autre côté (13) une couche de protection (15) électriquement isolante et
sachant que l'élément porteur (11) est configuré flexible, en particulier sous forme de feuille support.

2. Système selon la revendication 1, **caractérisé en ce que** le connecteur (24) du dispositif (10) est configuré sous forme de connecteur femelle (24).

3. Système selon l'une des revendications 1 ou 2, **caractérisé en ce que** le connecteur (24) est relié par brasage, collage ou soudage à l'élément support (11), ou est configuré monobloc avec lui.

4. Système selon l'une des revendications 1 à 3, **caractérisé en ce que** le connecteur (24) est configuré de sorte à ne pouvoir enficher le connecteur antagoniste (30) que dans une direction.

5. Système selon l'une des revendications 1 à 4, **caractérisé en ce que** l'élément support (11) et/ou la couche de colle (14) et/ou la couche de protection (15) sont configurés transparents et/ou incolores.

6. Système selon l'une des revendications 1 à 5, **caractérisé en ce que** les surfaces de contact (21) de chaque piste électroconductrice (20) respective sont conçues plus larges que la piste électroconductrice (20) elle-même.

7. Système selon l'une des revendications 1 à 6, **caractérisé en ce que** le support (40) présente deux pattes (41, 42) contre lesquelles sont agencées les deux surfaces de contact (21) de l'élément porteur (11) lorsque le dispositif (10) est monté, et qu'il est possible de faire entrer en liaison électrique efficace en introduisant le support (40) dans le profilé (50) avec les deux rails électriques (51, 52) du profilé (50).

8. Système selon l'une des revendications 1 à 7, **caractérisé en ce que** le rail électrique (51) mis sous tension est agencé, dans le sens d'introduction (43) du support (40), derrière le rail électrique (52) de retour.

9. Système selon la revendication 8, **caractérisé en ce que** la patte (41) qui peut être amenée à engrener avec le rail électrique (51) sous tension est configurée plus longue, dans le sens d'introduction (43) du support (40), que l'autre patte (42) qui peut être amenée à engrener dans le rail électrique de retour (52).
